# EUROPÄISCHE PATENTSCHRIFT

(11) **EP 1 425 803 B1**
(45) Veröffentlichungstag und Bekanntmachung des Hinweises auf die Patenterteilung: **07.12.2005**
(21) Anmeldenummer: 02769953.7
(22) Anmeldetag: 13.09.2002
(51) Int. Cl.: H01L 33/00, H01L 51/20

(54) **Elektrolumineszente Lichtemissionseinrichtung**
LED
Dispositif électroluminescent

(30) Priorität: 14.09.2001 DE 10145492
(43) Veröffentlichungstag der Anmeldung: 09.06.2004
(73) Patentinhaber: Novaled GmbH, 01307 Dresden (DE)
(72) Erfinder: LEO, Karl, 01219 Dresden (DE)
(74) Vertreter: Bittner, Thomas L.
(86) Internationale Anmeldenummer: PCT/DE2002/003426
(87) Internationale Veröffentlichungsnummer: WO 2003/026030

(56) Entgegenhaltungen:
- DE-A- 19 916 745
- GB-A- 2 353 400
- US-A- 6 163 038
- LIDZEY D G ET AL: "PIXELATED MULTICOLOR MICROCAVITY DISPLAYS" IEEE JOURNAL OF SELECTED TOPICS IN QUANTUM ELECTRONICS, IEEE SERVICE CENTER, US, Bd. 4, Nr. 1, 1998, Seiten 113-118, XP000766111 ISSN: 1077-260X

## Beschreibung

Die Erfindung bezieht sich auf das Gebiet der elektroiumineszenten Lichtemissionseinrichtungen und betrifft insbesondere eine elektrolumineszente Lichtemissionseinrichtung nach dem Oberbegriff des Patentanspruchs 1, welche als Weißlichtquelle verwendet werden kann.

In dem Bestreben, herkömmliche Weißlichtquellen auf der Basis von Glüh- oder Halogenlampen zu ersetzen, sind in der Vergangenheit verschiedene Konzepte entwickelt worden.

Das am weitesten fortgeschrittene Konzept beruht auf einer Halbleiter-LED auf der Basis von GaN oder InGaN, die zumindest teilweise in ein transparentes Gießharzmaterial eingebettet ist, in welchem eine Konvertersubstanz für eine zumindestens teilweisen Wellenlängenkonversion des von der LED emittierten Lichts enthalten ist. Vorzugsweise weist dabei die LED eine Mehrzahl von lichtemittierenden Zonen auf, durch die ein relativ breitbandiges Lichtemissionsspektrum energetisch oberhalb des Emissionsspektrums der Konvertersubstanz erzeugt wird. Das von der GaN-LED emittierte Licht im blauen oder UV-Wellenlängenbereich wird beim Durchtritt durch die Gießharzmasse mindestens teilweise durch die Konvertersubstanz in Licht mit einer Wellenlänge im gelben Spektralbereich umgewandelt, so dass durch additive Farbmischung weißes Licht erzeugt wird. Auf der Basis dieses Konzepts sind vor kurzem kleinformatige Leuchtquellen wie Taschenlampen und dergleichen auf den Markt gebracht worden. Diese Produkte weisen jedoch noch verschiedene Nachteile auf. Zum einen ist die spektrale Lichtemissionskurve dieser Weißlichtquellen noch nicht optimal, so dass der physiologisch-optische Eindruck einer Weißlichtquelle vielfach - zumindest nicht unter allen Betrachtungswinkeln - gegeben ist. Des Weiteren ist die Leuchtstärke der nach diesem Konzept herstellbaren Weißlichtquellen aufgrund der noch zu geringen Lichtleistung der GaN-LEDs und der notwendigen Lichtkonversion begrenzt. Großflächige Weißlichtquellen mit hoher Leuchtstärke werden daher in naher Zukunft nach diesem Konzept nicht zu erwarten sein.

Ein weiteres Konzept zur Herstellung von Weißlichtquellen beruht auf der monolithischen Integration mehrerer Halbleiterschichten und entsprechender pn-Übergänge auf einem Substrat, wobei die Halbleitermaterialien derart zusammengesetzt sind, dass in den pn-Übergängen durch Strominjektion Licht mit verschiedenen Wellenlängen erzeugt wird. In der US-A-6 163,038 wird eine derartige Weißlichtquelle auf der Basis des Materialsystems GaN beschrieben. In zwei Ausführungsformen werden Bauelemente beschrieben, bei denen eine Halbleiterschichtenfolge mit drei pn-Übergängen erzeugt wird, die Licht mit Wellenlängen der Komplementärfarben Rot, Grün und Blau emittieren, wodurch der optische Effekt einer Weißlichtquelle hervorgerufen wird. Dieses Konzept hat den Vorteil, dass sich im Prinzip mischfarbiges Licht jeder beliebigen Farbe erzeugen lässt, wodurch sich eine Vielzahl von Anwendungen im Bereich von Anzeige- und Beleuchtungsvorrichtungen ergibt. Auch mit Bauelementen dieser Art wird es jedoch nicht möglich sein, leuchtstarke und großflächige Beleuchtungseinrichtungen unter einem vertretbaren Kostenaufwand herzustellen.

Ein weiteres Konzept für Weißlichtquellen beruht auf organischen Leuchtdioden (OLED), welche sich in letzter Zeit rapide entwickelt haben und bereits in Anzeigevorrichtungen von Kraftfahrzeugen kommerziell eingesetzt werden. Organische Leuchtdioden können weißes Licht relativ einfach erzeugen, da durch die große Vielfalt an organischen Substanzen verschiedene Emitter zusammengebracht werden können, um weißes Licht zu erzeugen. In der deutschen Offenlegungsschrift DE 199 16 745 A1 wird eine lichtemittierende Diode mit organischen lichtemittierenden Stoffen zur Erzeugung von Licht mit Mischfarben beschrieben, bei welcher eine Schicht enthaltend organische lichtemittierende Stoffe zwischen zwei Elektrodenschichten und zwei Substratträgern angeordnet ist, wobei einer der Träger durch eine Streuscheibe gebildet sein kann. Die organische Lichtemitterschicht weist eine Streifenstruktur auf, bei der mindestens zwei Typen von Streifen alternierend angeordnet sind und Streifen eines Typs jeweils organische lichtemittierende Stoffe aufweisen, die Licht einer bestimmten Farbe emittieren, wobei Streifen eines Typs gemeinsam angesteuert werden. Die organischen lichtemittierenden Stoffe der zwei oder drei Streifentypen sind so gewählt, dass bei geeigneter Ansteuerung die Mischung des abgestrahlten Lichts der Streifen weißes Licht ergibt. Ein Nachteil des in der Ausführungsform beschriebenen Bauelements besteht jedoch darin, dass die Breite der Streifen der Lichtemitterschichten so gering ist, dass die Streifenstruktur bei normaler Betrachtung mit dem menschlichen Auge nicht mehr auflösbar ist, wodurch die Herstellung des Bauelements relativ aufwendig wird.

Es ist demgemäß Aufgabe der vorliegenden Erfindung, eine elektrolumineszente Lichtemissionseinrichtung anzugeben, mit der sichtbares Licht verschiedener Wellenlänge erzeugbar und additiv mischbar ist und die kostengünstig hergestellt werden kann. Die elektrolumineszente Lichtemissionseinrichtung soll insbesondere als Weißlichtquelle verwendet werden können.

Diese Aufgabe wird mit den kennzeichnenden Merkmalen des Patentanspruchs 1 gelöst. Vorteilhafte Weiterbildungen und Ausgestaltungen sind in den Unteransprüchen angegeben.

Die vorliegende Erfindung geht aus von einer Lichtemissionseinrichtung wie sie in der bereits genannten Druckschrift DE 199 16 745 beschrieben wurde und bei welcher die Lichtemitterschichten in Form einer Streifenstruktur alternierend lateral nebeneinander zwischen den Elektrodenschichten angeordnet sind. Der vorliegenden Erfindung liegt die wesentliche Erkenntnis zugrunde, dass es nicht unbedingt notwendig ist, zur additiven Farbmischung der von den Lichtemitterstreifen emittierten Strahlungsbündel eine mikroskopische Strukturierung der Streifenstruktur vorzusehen. Vielmehr ist es ein wesentliches Merkmal der vorliegenden Erfindung, dass die laterale Ausdehnung und/oder der laterale Abstand der Lichtemitterschichten voneinander in einer Größenordnung liegt, dass er mit dem menschlichen Auge bei bloßer Betrachtung auflösbar ist. Für die Farbmischung der von den Lichtemitterschichten emittierten Strahlungsbündel ist es dann notwendig, dass die Dicke des als Streuscheibe ausgebildeten Substrats derart gewählt ist, dass die von den Lichtemitterschichten emittierten Strahlungsbündel sich auf der lichtaustrittsseitigen Oberfläche des Substrats mindestens teilweise überlagern. Das Substrat muss also mindestens so dick sein, dass die einzelnen zu mischenden Strahlungsbündel beim Durchtritt durch das Substrat eine ausreichende Streuverbreiterung erfahren.

Es bedarf somit keiner aufwendigen Maskierungs- und Strukturierungsschritte, wie sie etwa aus der Mikroelektronik bekannt sind, um eine erfindungsgemäße elektrolumineszente Lichtemissionseinrichtung zu fertigen. Es können makroskopische laterale Ausdehnungen der Lichtemitterschichten vorgesehen werden, die durch einfache Strukturierungsmaßnahmen hergestellt werden können.

Ein für die Auflösung des menschlichen Auges bekannter Standardwert beträgt 1 Winkelminute = 1/60 Grad. Bei einem Betrachtungsabstand von 1 m von den Lichtemitterschichten entspricht dies 0,29 mm. Wenn man einen Betrachtungsabstand von 30 cm annimmt, so ergibt sich eine Auflösung von ca. 100 µm. Als eine sinnvolle untere Grenze für noch für das menschliche Auge auflösbare laterale Dimensionen der Lichtemitterschichten kann somit ein Wert von ca. 100 µm für den lateralen Abstand und/oder die Breite von streifenförmigen Lichtemitterschichten angenommen werden.

Bezüglich der Dicke des als Streuscheibe ausgebildeten Substrats sollte diese grösser, vorzugsweise deutlich grösser als die mittlere Streulänge für die von den Lichtemitterschichten emittierten Strahlungsbündel in der Streuscheibe sein. Unter der Streulänge kann in einer etwas vereinfachten Definition hier die mittlere freie Weglänge verstanden werden, die ein Photon einer gegebenen Frequenz zurücklegt, bevor es durch eine Streuung seine Richtung ändert. Eine Streuscheibe mit relativ stark streuenden Eigenschaften besitzt somit eine entsprechend kurze mittlere Streulänge, so dass die Dicke der Streuscheibe entsprechend kleiner bemessen werden kann als bei einer Streuscheibe mit weniger stark streuenden Eigenschaften. Um zu einer ausreichenden Überlagerung der verschiedenen Strahlungsbündel zu kommen, sollte für die Dicke der Streuscheibe ferner der Abstand der Lichtemitterschichten eine Rolle spielen. Vorzugsweise sollte die Dicke der Streuscheibe zusätzlich zu dem oben genannten Kriterium mindestens in etwa so gross wie der Abstand der Lichtemitterschichten gewählt werden.

Die Lichtemitterschichten sind dabei vorzugsweise in an sich bekannter Weise aus organischen Materialien hergestellt. Wie erst vor kurzem experimentell gezeigt worden ist, können hierfür geeignete organische Materialien so abgeschieden werden, dass durch zwei elektronen- bzw. löcherinjizierende Elektroden Ladungsträger in die organischen Schichten eintreten können und somit eine organische Leuchtdiode (OLED) ausgebildet wird.

Es sind zwei oder mehr verschiedene Arten von Lichtemitterschichten mit verschiedenen Emissionsspektren vorgesehen, durch deren Mischung Weißlicht erzeugt werden kann. Es kann vorgesehen sein, dass sich beidseits der Lichtemitterschichten zwei unstrukturierte Elektrodenschichten erstrecken, so dass die Lichtemitterschichten stets gemeinsam angesteuert werden. In diesem Fall kann jedoch nicht der Tatsache Rechnung getragen werden, dass die verschiedenen organischen Materialien der Lichtemitterschichten unterschiedlichen Alterungszeiten unterworfen sind, so dass im Laufe der Zeit der optische Eindruck einer Weißlichtquelle verlorengeht, da eine der Lichtemitterschichten schneller ihre Leuchtkraft verliert als die anderen.

Eine vorteilhafte Ausführungsform sieht daher vor, dass auf einer Seite der Lichtemitterschichten eine Mehrzahl von Elektroden derart angeordnet ist, dass Lichtemitterschichten mit verschiedenem Emissionsspektrum getrennt voneinander und solche mit gleichem Emissionsspektrum gemeinsam ansteuerbar sind. Somit kann im Gebrauch die gegebenenfalls nachgelassene Leuchtkraft eines Typs von Lichtemitterschichten durch eine Beaufschlagung mit einer erhöhten Spannung entsprechend kompensiert werden. Unabhängig von dieser Problematik unterschiedlicher Alterungszeiten der organischen Materialien kann diese Ausführungsform dafür benutzt werden, die Farbgebung einer durch die Weißlichtquelle gebildeten Beleuchtungseinrichtung nach individuellen Wünschen zu steuern, d.h. beispielsweise innerhalb des Weißlichtspektrums die rote oder die blaue Farbkomponente stärker oder schwächer hervorzuheben.

In einer einfachen Ausführungsform, die beispielsweise für eine kleinformatige Weißlicht-LED verwendet werden kann, kann vorgesehen sein, dass die für die Lichtmischung vorgesehenen Emissionsspektren nur durch jeweils eine Lichtemitterschicht repräsentiert werden. Es sind jedoch auch Ausführungsformen denkbar, insbesondere für großflächige Beleuchtungseinrichtungen, bei denen die Emissionsspektren durch jeweils eine Mehrzahl von Lichtemitterschichten repräsentiert werden. Falls die Lichtemitterschichten streifenförmig strukturiert sind, so können in diesem Fall die Lichtemitterschichten nach ihrem Emissionsspektrum in alternierender Reihenfolge angeordnet sein.

Es ist jedoch nicht notwendiger Bestandteil der Erfindung, dass die Lichtemitterschichten streifenförmig strukturiert sind. Die Lichtemitterschichten können vielmehr auch als punkt- oder kreisscheibenförmige Schichten lateral nebeneinander angeordnet sein. Insbesondere wenn die Lichtemitterschichten in ihren Emissionsspektren durch rot, grün und blau emittierende Lichtemitterschichten gebildet sind, können die Lichtemitterschichten in Form eines Farbtripels aus drei kreispunktförmigen Lichtemitterschichten angeordnet sein, wie es aus der Farbbildschirmtechnik an sich bekannt ist._Bei einer solchen Ausführungsform können bezüglich des Kriteriums der Auflösbarkeit mit dem menschlichen Auge für den Durchmesser der kreisförmigen Schichten und/oder für den gegenseitigen Abstand von deren Mittelpunkten ebenfalls ein Wert von ca. 100 µm als untere Grenze angenommen werden.

Eine vorteilhafte Ausführungsform sieht drei Arten von Lichtemitterschichten vor, deren im wesentlichen monochromatische Emissionsspektren jeweils Maxima im roten, grünen und blauen Wellenlängenbereich aufweisen. Durch die Mischung der drei Komplementärfarben wird Weißlicht erzeugt, wenn sie mit gleicher Leuchtstärke von den Lichtemitterschichten emittiert werden.

Es kann jedoch auch vorgesehen sein, nur zwei Arten von Lichtemitterschichten zu verwenden, deren Emissionsspektren jeweils Maxima im gelben und blauen Wellenlängenbereich aufweisen, wobei die gelbe Lichtemitterschicht mit einer höheren Leuchtkraft eingestellt werden muss.

Es ist auch denkbar, mehr als drei Arten von Lichtemitterschichten mit verschiedenen Emissionsspektren einzusetzen, etwa um eine möglichst optimale Anpassung des Weißlichtspektrums an Tageslicht zu ermöglichen.

Im folgenden wird eine Ausführungsform der erfindungsgemäßen Lichtemissionseinrichtung anhand der Figuren näher erläutert. Es zeigen:
- Fig. 1: eine Seiten- oder Schnittansicht einer erfindungsgemäßen Weißlichtquelle;
- Fig. 2: eine Draufsicht auf die Weißlichtquelle der Fig. 1.

In den Figuren ist eine Ausführungsform bestehend aus drei verschiedenfarbig emittierenden Lichtemitterschichten dargestellt. Die Lichtemitterschichten werden durch organische LEDs gebildet.

Auf einem lichtstreuenden Substrat 4, welches beispielsweise durch eine Milchglasscheibe oder ein Kunststoffsubstrat mit eingebetteten Streuzentren gebildet sein kann, wird eine erste transparente Elektrodenschicht 7 aufgebracht. Die Elektrodenschicht 7 kann beispielsweise durch eine ITO-(Indiumzinnoxid)Schicht gebildet sein.

Anschließend werden auf die erste Elektrodenschicht 7 nacheinander Lichtemitterschichten 1, 2 und 3 streifenförmig aufgebracht. Die Lichtemitterschichten 1, 2 und 3 bestehen jeweils aus einer Schichtenfolge aus n- und p-dotierten organischen Materialien, so dass innerhalb der Schichtenfolge ein pn-Übergang gebildet wird. Die organischen Materialien sind derart gewählt, dass die erste Lichtemitterschicht 1 ein Emissionsmaximum bei einer Wellenlänge im roten Spektralbereich hat, die zweite Lichtemitterschicht 2 ein Emissionsmaximum bei einer Wellenlänge im grünen Spektralbereich hat und die dritte Lichtemitterschicht 3 ein Emissionsmaximum bei einer Wellenlänge im blauen Spektralbereich aufweist.

Die streifenförmigen Lichtemitterschichten 1, 2 und 3 können mit bloßem Auge auf dem Substrat 4 wahrgenommen werden und weisen beispielsweise eine Streifenbreite von etwa 1 mm auf.

Exemplarisch ist das von der ersten Lichtemitterschicht 1 emittierte Strahlungsbündel dargestellt. Für die Farbmischung und die Weißlichterzeugung ist von Bedeutung, dass die mittlere laterale Streuverbreiterung des emittierten Lichts deutlich größer ist als die Breite der streifenförmigen Lichtemitterschichten. Nur wenn es auf der den Lichtemitterschichten gegenüberliegenden lichtaustrittsseitigen Oberfläche des Substrats 4 zu einer ausreichenden Überlagerung der von den Lichtemitterschichten 1, 2 und 3 emittierten Strahlungsbündel kommt, wird die Lichtemissionseinrichtung im Gebrauch als Weißlichtquelle von einem Betrachter wahrgenommen.

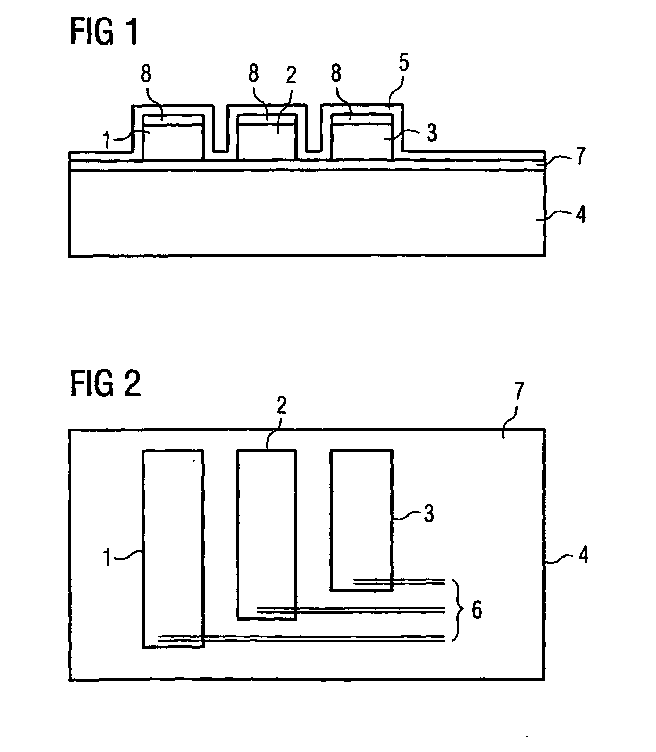

Auf den rückseitigen Oberflächen der streifenförmigen Lichtemitterschichten 1, 2 und 3 werden jeweils Elektrodenschichten 8 aufgebracht. Auf die gesamte Struktur wird schließlich eine reflektierende Schicht 5 aufgebracht, die dafür sorgt, dass das von den pn-Übergängen der Lichtemitterschichten, 1, 2 und 3 in rückwärtiger Richtung emittierte Licht nach vorne in Richtung auf das Substrat 4 reflektiert wird. Die reflektierende Schicht 5 kann als metallische oder auch dielektrische Schicht ausgeführt sein. Anschließend können Zuleitungsdrähte 6 (in Fig.1 nicht dargestellt) zu jeder der drei OLEDs gelegt und jeweils mit den Elektrodenschichten 8 verbunden werden. Über die Zuleitungsdrähte 6 können die OLEDs mit verschiedenen Spannungen aus Spannungsquellen beaufschlagt werden, deren gemeinsamer Gegenpol mit der ersten Elektrodenschicht 7 verbunden ist.

In dem gezeigten Ausführungsbeispiel ist jeder Emissionstyp nur durch eine Lichtemitterschicht repräsentiert. Für den Fall, dass eine höhere Leuchtstärke und/oder eine größere Beleuchtungsfläche gewünscht wird, können weitere Streifen von Lichtemitterschichten in alternierender Reihenfolge ihres spektralen Typs aufgebracht werden.

## Patentansprüche

1. Elektrolumineszente Lichtemissionseinrichtung, insbesondere zur Verwendung als Weißlichtquelle, enthaltend:
- ein transparentes, als Streuscheibe ausgebildetes Substrat (4),
- mindestens eine auf das Substrat (4) aufgebrachte erste transparente Elektrodenschicht (7),
- eine Anzahl elektrolumineszenter Lichtemitterschichten (1, 2, 3), welche lateral nebeneinander auf der ersten Elektrodenschicht (7) angeordnet sind und aus deren Emissionsstrahlung durch additive Farbmischung Weißlicht erzeugbar ist, und
- mindestens eine zweite Elektrodenschicht (5), welche auf die Lichtemitterschichten (1, 2, 3) aufgebracht ist,
**dadurch gekennzeichnet, dass**
- die laterale Ausdehnung und/oder der laterale Abstand der Lichtemitterschichten (1, 2, 3) mindestens 100 µm betragen,
- die Streuscheibe eine Milchglasscheibe oder ein Kunststoffsubstrat mit eingebetteten Streuzentren ist und ihre Dicke größer als die mittlere Streulänge der zu mischenden Strahlungsbündel der Lichtemitterschichten (1, 2, 3) und mindestens so groß wie der Abstand der Lichtemitterschichten (1, 2, 3) ist, so dass
- die von den Lichtemitterschichten (1, 2, 3) emittierten Strahlungsbündel sich auf der lichtaustrittsseitigen Oberfläche des Substrats (4) mindestens teilweise überlagern.

2. Elektrolumineszente Lichtemissionseinrichtung nach Anspruch 1,
**dadurch gekennzeichnet, dass**
- die Lichtemitterschichten (1, 2, 3) aus organischen Materialien hergestellt sind.

3. Elektrolumineszente Lichtemissionseinrichtung nach Anspruch 1 oder 2,
**dadurch gekennzeichnet, dass**
- eine Mehrzahl von ersten und/oder zweiten Elektroden (7, 5) derart angeordnet ist, dass Lichtemitterschichten (1, 2, 3) mit verschiedenem Emissionsspektrum getrennt voneinander und solche mit gleichem Emissionsspektrum gemeinsam ansteuerbar sind.

4. Elektrolumineszente Lichtemissionseinrichtung nach einem der Ansprüche 1 bis 3,
**dadurch gekennzeichnet, dass**
- die bereitgestellten Emissionsspektren nur durch jeweils eine Lichtemitterschicht (1, 2, 3) repräsentiert werden.

5. Elektrolumineszente Lichtemissionseinrichtung nach einem der Ansprüche 1 bis 3,
**dadurch gekennzeichnet, dass**
- die bereitgestellten Emissionsspektren durch jeweils eine Mehrzahl von Lichtemitterschichten bereitgestellt werden.

6. Elektrolumineszente Lichtemissionseinrichtung nach einem der vorhergehenden Ansprüche,
**dadurch gekennzeichnet, dass**
- die Lichtemitterschichten (1, 2, 3) streifenförmig sind und parallel zueinander angeordnet sind.

7. Elektrolumineszente Lichtemissionseinrichtung nach den Ansprüchen 5 und 6,
**dadurch gekennzeichnet, dass**
- die Lichtemitterschichten nach ihrem Emissionsspektrum in alternierender Reihenfolge angeordnet sind.

8. Elektrolumineszente Lichtemissionseinrichtung nach einem der vorhergehenden Ansprüche,
**gekennzeichnet durch**
- drei Arten von Lichtemitterschichten (1, 2, 3), deren Emissionsspektren jeweils Maxima im roten, grünen und blauen Wellenlängenbereich aufweisen.

9. Elektrolumineszente Lichtemissionseinrichtung nach einem der Ansprüche 1 bis 7,
**gekennzeichnet durch**
- zwei Arten von Lichtemitterschichten, deren Emissionsspektren jeweils Maxima im gelben und blauen Wellenlängenbereich aufweisen.

10. Elektrolumineszente Lichtemissionseinrichtung nach einem der vorhergehenden Ansprüche,
**dadurch gekennzeichnet, dass**
- die Lichtemitterschichten (1, 2, 3) auf ihrer dem Substrat (4) abgewandten Oberfläche mit einer reflektierenden Schicht (5) versehen sind.

11. Elektrolumineszente Lichtemissionseinrichtung nach Anspruch 10,
**dadurch gekennzeichnet, dass**
- die zweite Elektrodenschicht gleichzeitig als reflektierende Schicht dient.

12. Elektrolumineszente Lichtemissionseinrichtung nach einem der vorhergehenden Ansprüche,
**dadurch gekennzeichnet, dass**
- die erste Elektrodenschicht (7) eine auf das Substrat (4) aufgebrachte ITO-Schicht ist.

## Claims

1. An electroluminescent light emission device, in particular for use as a white light source, comprising:
- a transparent substrate (4) formed as a diffusing screen,
- a least one first transparent electrode layer (7) applied to the substrate (4),
- a number of electroluminescent light emitter layers (1, 2, 3) arranged laterally next to one another on the first electrode layer (7) and from whose emission radiation white light can be generated by means of additive color mixing, and
- at least one second electrode layer (5) applied to the light emitter layers (1, 2, 3);
**characterized in that**
- the lateral extent and/or the lateral distance of the light emitter layers (1, 2, 3) amount to at least 100 µm,
- the diffusing screen is an opal glass screen or a plastic substrate with embedded scattering centers and its thickness is larger than the average scattering length of the radiation beams to be mixed of the light emitter layers (1, 2, 3) and is at least as large as the distance between the light emitter layers (1, 2, 3), whereby,
- the radiation beams emitted by the light emitter layers (1, 2, 3) are at least partly superposed on a light exit surface of the substrate (4).

2. The electroluminescent light emission device as claimed in claim 1,
**characterized in that**
- the light emitter layers (1, 2, 3) are produced from organic materials.

3. The electroluminescent light emission device as claimed in claim 1 or 2,
**characterized in that**
- a plurality of first and/or second electrodes (7, 5) are arranged in such a way that lightemitter layers (1, 2, 3) with a different emission spectrum can be driven separately from one another and those with an identical emission spectrum can be driven jointly.

4. The electroluminescent light emission device as claimed in one of claims 1 to 3,
**characterized in that**
- the emission spectra provided are represented only by in each case one light emitter layer (1, 2, 3).

5. The electroluminescent light emission device as claimed in one of claims 1 to 3,
**characterized in that**
- the emission spectra are provided by in each case a plurality of light emitter layers.

6. The electroluminescent light emission device as claimed in one of the preceding claims,
**characterized in that**
- the light emitter layers (1, 2, 3) are in strip form and are arranged parallel to one another.

7. The electroluminescent light emission device as claimed in claims 5 and 6,
**characterized in that**
- the light emitter layers are arranged in an alternate order according to their emission spectrum.

8. The electroluminescent light emission device as claimed in one of the preceding claims,
**characterized by**
- three types of light emitter layers (1, 2, 3), the mission spectra of which respectively have maxima in the red, green and blue wavelength ranges.

9. The electroluminescent light emission device as claimed in one of claims 1 to 7,
**characterized by**
- two types of light emitter layers, the emission spectra of which respectively have maxima in the yellow and blue wavelength ranges.

10. The electroluminescent light emission device as claimed in one of the preceding claims,
**characterized in that**
- the light emitter layers (1, 2, 3) are provided with a reflective layer (5) on their surface remote from the substrate (4).

11. The electroluminescent light emission device as claimed in claim 10,
**characterized in that**
- the second electrode layer simultaneously serves as the reflective layer.

12. The electroluminescent light emission device as claimed in one of preceding claims,
**characterized in that**
- the first electrode layer (7) is an ITO layer applied to the substrate (4).

## Revendications

1. Dispositif d'émission lumineuse à électroluminescence, en particulier pour utilisation en tant que source de lumière blanche, contenant :
◆ un substrat (4) transparent, conformé en panneaux de dispersion,
◆ au moins une première couche d'électrodes (7) transparentes, appliquée sur le substrat (4),
◆ une pluralité de couches photoémettrices (1, 2, 3) électroluminescentes, disposées latéralement les unes à côté des autres sur la première couche d'électrodes (7), et de la lumière blanche étant susceptible d'être produite à partir de son rayonnement d'émission, par mélange additif des couleurs, et
◆ au moins une deuxième couche d'électrodes (5), appliquée sur les couches photoémettrices (1, 2, 3),
**caractérisé en ce que**
◆ l'étendue latérale et/ou l'espacement latéral des couches photoémettrices (1, 2, 3) s'élève à au moins 100 µm,
◆ le panneau de dispersion est un panneau en verre mat ou opalin, ou bien un substrat en matière synthétique, ayant des centres de dispersion intégrés, et son épaisseur est supérieure à la longueur de dispersion moyenne des faisceaux de rayonnement à mélanger des couches photoémettrices (1, 2, 3) et au moins aussi grande que la valeur de l'espacement des couches photo-émettrices (1, 2, 3), de manière que
◆ les faisceaux de rayonnement émis par les couches photoémettrices (1, 2, 3) se superposent au moins partiellement sur la surface, située côté sortie de la lumière, du substrat (4).

2. Dispositif de photo-émission électroluminescent selon la revendication 1, **caractérisé en ce que** les couches photo-émettrices (1, 2, 3) sont produites à partir de matériaux organiques.

3. Dispositif de photo-émission électroluminescent selon la revendication 1 ou 2, **caractérisé en ce qu'**une pluralité de première et/ou de deuxième électrodes (7, 5) sont disposées de manière que des couches photoémettrices (1, 2, 3) à spectre d'émission différent puissent être commandées séparément les unes des autres, et que celles ayant le même spectre d'émission puissent être commandées conjointement.

4. Dispositif de photo-émission électroluminescent selon l'une des revendications 1 à 3, **caractérisé en ce que** les spectres d'émission fournis ne sont représentés que chaque fois par une couche photo-émettrice (1, 2, 3).

5. Dispositif de photo-émission électroluminescent selon l'une des revendications 1 à 3, **caractérisé en ce que** les spectres d'émission fournis sont produits à chaque fois par une pluralité de couches photo-émettrices.

6. Dispositif de photo-émission électroluminescent selon l'une des revendications précédentes, **caractérisé en ce que** les couches photo-émettrices (1, 2, 3) se présentent en forme de bande et sont disposées parallèlement les unes aux autres.

7. Dispositif de photo-émission électroluminescent selon l'une des revendications 5 et 6, **caractérisé en ce que** les couches photo-émettrices sont disposées selon un ordre de succession alterné, d'après leur spectre d'émission.

8. Dispositif de photo-émission électroluminescent selon l'une des revendications précédentes, **caractérisé par** trois types de couches photo-émettrices (1, 2, 3), dont les spectres d'émission présentent chacun des maximas dans la plage de longueurs d'onde rouges, vertes et bleus.

9. Dispositif de photo-émission électroluminescent selon l'une des revendications 1 à 7, **caractérisé par** deux types de couches photo-émettrices dont les spectres d'émission présentent chaque fois des maximas dans la plage de longueurs d'onde jaunes et bleus.

10. Dispositif de photo-émission électroluminescent selon l'une des revendications précédentes, **caractérisé en ce que** les couches photo-émettrices (1, 2, 3) sont munies, sur leur surface, opposée au substrat (4), d'une couche (5) réfléchissante.

11. Dispositif de photo-émission électroluminescent selon la revendication 10, **caractérisé en ce que** la deuxième couche d'électrodes sert simultanément de couche réfléchissante.

12. Dispositif de photo-émission électroluminescent selon l'une des revendications précédentes, **caractérisé en ce que** la première couche d'électrodes (7) est une couche d'ITO (oxyde d'étain dopé à l'indium), appliquée sur le substrat (4).
